# EUROPEAN PATENT APPLICATION

(11) **EP 4 810 901 A1**
(43) Date of publication of application: **23.09.2026**
(21) Application number: 23958853.6
(22) Date of filing: 15.11.2023
(51) Int. Cl.: G01B 17/02, C23C 14/24, C23C 14/52, G01N 5/02

(54) **SENSOR MODULE AND MEASUREMENT SYSTEM**

(71) Applicant: Nihon Dempa Kogyo Co., Ltd., Tokyo 151-8569 (JP)
(72) Inventor: ONISHI Naoki, Sayama-shi, Saitama 350-1321 (JP); KUKITA Hiroyuki, Sayama-shi, Saitama 350-1321 (JP)
(74) Representative: Plougmann Vingtoft a/s
(86) International application number: PCT/JP2023/041125
(87) International publication number: WO 2025/104847

(57) **Abstract**

A sensor module according to the present invention comprises: a piezoelectric oscillator that has an electrode; an oscillation circuit that drives and oscillates the piezoelectric oscillator; and a storage circuit that stores, as initial oscillation frequency information, an oscillation frequency that is measured by oscillating the piezoelectric oscillator when the piezoelectric oscillator is shipped, wherein when the piezoelectric oscillator is driven by the oscillation circuit, the piezoelectric oscillator oscillates at a frequency corresponding to the thickness of a deposit that has been deposited on a surface of the electrode. The storage circuit may store information pertaining to a first identification number for identifying the piezoelectric oscillator and/or a second identification number for identifying the sensor module.

## Description

### TECHNICAL FIELD

The present disclosure relates to a sensor module and a measurement system.

### BACKGROUND ART

Conventionally, a Quartz Crystal Microbalance (QCM) sensor using a quartz crystal resonator is known. The QCM sensor is capable of detecting the presence or absence of a substance based on a difference between a resonance frequency of a reference quartz crystal resonator and a resonance frequency of a detection quartz crystal resonator to which the substance adheres (see Patent Document 1).

### PRIOR ART

### PATENT DOCUMENT

Patent Document 1: Japanese Unexamined Patent Application Publication No. 2018-080947

### SUMMARY OF INVENTION

### PROBLEMS TO BE SOLVED BY THE INVENTION

Such a sensor can be used, by being installed in an apparatus that deposits a material, such as a semiconductor manufacturing apparatus, as a sensor that detects a thickness of the material deposited based on a change in a resonance frequency of a resonator on which the material has been deposited. However, as an amount of the material deposited on the resonator increases, the resonator may exceed its oscillation limit, and the sensor may become unable to operate while the semiconductor manufacturing apparatus is depositing the material.

The present disclosure focuses on this point, and an object thereof is to estimate a lifetime of a resonator mounted on a sensor that detects an amount of deposited material using the resonator.

### MEANS FOR SOLVING THE PROBLEMS

A first aspect of the present disclosure provides a sensor module including a piezoelectric resonator that includes an electrode, an oscillation circuit that drives and oscillates the piezoelectric resonator, and a storage circuit that stores, as initial oscillation frequency information, an oscillation frequency measured by causing the piezoelectric resonator to oscillate upon shipment of the piezoelectric resonator, wherein the piezoelectric resonator, when driven by the oscillation circuit, oscillates at a frequency corresponding to a thickness of a deposit deposited on a surface of the electrode.

The storage circuit may further store information of an identification number of at least one of a first identification number for identifying the piezoelectric resonator or a second identification number for identifying the sensor module.

The storage circuit may be configured to be capable of updating information by overwriting a storage area for information stored in the past.

A second aspect of the present disclosure provides a measurement system including the sensor module according to the first aspect, and a control device that is connected to the sensor module, wherein the control device includes a frequency measurement unit that measures an oscillation frequency of the piezoelectric resonator based on an oscillation frequency signal output from the oscillation circuit, a memory control unit that is capable of accessing the storage circuit of the sensor module to read information stored in the storage circuit, a thickness determination unit that determines the thickness of the deposit deposited on the surface of the electrode of the piezoelectric resonator based on the oscillation frequency measured by the frequency measurement unit, and a lifetime estimation unit that estimates a lifetime of the piezoelectric resonator based on the initial oscillation frequency information read from the storage circuit by the memory control unit and the oscillation frequency measured by the frequency measurement unit.

The sensor module further may further include a temperature sensor that measures a surface temperature of a substrate provided with the piezoelectric resonator, and an acquisition unit that acquires a measurement result obtained by the temperature sensor, wherein the lifetime estimation unit may estimate the lifetime of the piezoelectric resonator by comparing the initial oscillation frequency information with a compensated frequency obtained by performing a compensation, based on the surface temperature of the substrate, on the oscillation frequency measured by the frequency measurement unit.

The control device may further include an input unit that allows a user to input a measurement condition for measuring the thickness of the deposit, the memory control unit may be capable of accessing the storage circuit of the sensor module to write predetermined information to the storage circuit, and when the frequency measurement unit measures the oscillation frequency of the piezoelectric resonator after the input unit receives a predetermined operation indicating that the measurement system is installed, the memory control unit may update the initial oscillation frequency information stored in the storage circuit to the measured oscillation frequency information of the piezoelectric resonator.

### EFFECT OF THE INVENTION

According to the present disclosure, it is possible to estimate a lifetime of a resonator mounted on a sensor that detects an amount of deposited material using the resonator.

### BRIEF DESCRIPTION OF THE DRAWINGS

FIG. 1 shows an example in which a measurement system S according to the present embodiment is applied to a semiconductor manufacturing apparatus 1.
FIG. 2 shows a configuration example of a sensor module 10 according to the present embodiment.
FIG. 3 shows a configuration example of a control device 100 according to the present embodiment.
FIG. 4 shows an operational flow of the control device 100 according to the present embodiment.

### DESCRIPTION OF EMBODIMENTS

### <Example of measurement system S applied to semiconductor manufacturing apparatus 1>

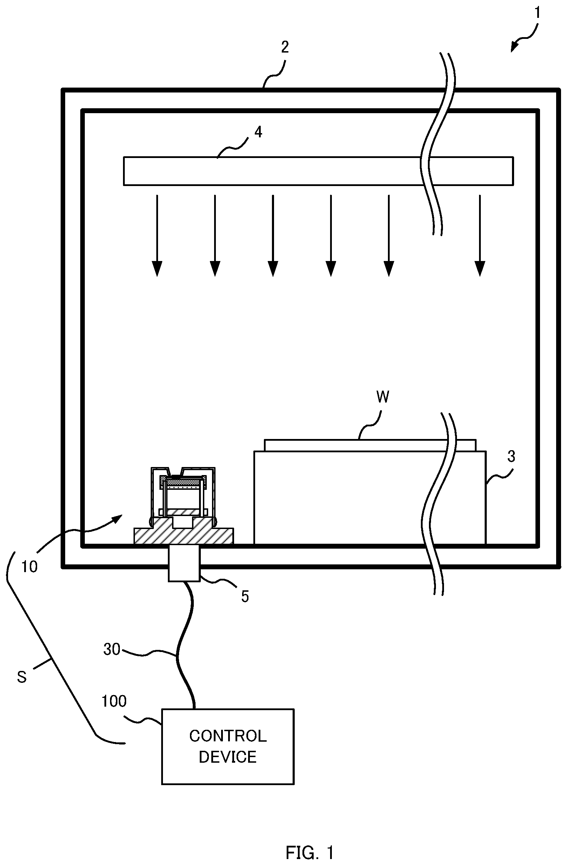

FIG. 1 shows an example in which a measurement system S according to the present embodiment is applied to a semiconductor manufacturing apparatus 1. The semiconductor manufacturing apparatus 1 is an apparatus for laminating a semiconductor material on a semiconductor wafer W. The semiconductor manufacturing apparatus 1 includes a chamber 2, a stage 3, and a film forming device 4.

The chamber 2 is a container that seals a predetermined space. The chamber 2 is a vacuum chamber capable of maintaining a sealed space at a reduced pressure, for example. The stage 3 is provided inside the chamber 2 and configured to support the semiconductor wafer W. The stage 3 may be configured to be movable in the chamber 2 while supporting the semiconductor wafer W.

The film forming device 4 is a device for depositing a material such as a metal, an insulator, or a semiconductor on a surface of the semiconductor wafer W. The film forming device 4 is a device that deposits a material by a liquid-phase method or a vapor-phase method, a device that applies a material, or the like. Various devices are known as the film forming device 4, and therefore a detailed description thereof is omitted herein. A semiconductor material is deposited on the surface of the semiconductor wafer W by such a film forming device 4, thereby forming a thin film.

In such a semiconductor manufacturing apparatus 1, a thickness of the semiconductor material deposited on the semiconductor wafer W can be estimated by using film forming conditions and a film forming time of the film forming device 4, for example. However, in some cases, it is desirable to measure an actual thickness of the semiconductor material deposited on the semiconductor wafer W. In particular, there are cases where it is desirable to measure the thickness of the semiconductor material in real time during deposition of the semiconductor material. Therefore, the measurement system S according to the present embodiment measures the thickness of the semiconductor material deposited on the surface of the semiconductor wafer W.

The measurement system S includes a sensor module 10, a connection cable 30, and a control device 100. The sensor module 10 is installed inside the chamber 2. Like the semiconductor wafer W, the sensor module 10 is provided in a region where the film forming device 4 can deposit a material, and measures the thickness of the material deposited thereon. The sensor module 10 and the control device 100 will be described later.

The connection cable 30 connects the sensor module 10 that is inside the chamber 2 and the control device 100 that is outside the chamber 2. The connection cable 30 connects the sensor module 10 and the control device 100 via a connector 5, for example. In this case, the connector 5 is provided in the chamber 2 and is configured to be capable of transmitting and receiving electrical signals while maintaining airtightness of the chamber 2. Next, the sensor module 10 of the measurement system S will be described.

### <Configuration example of sensor module 10>

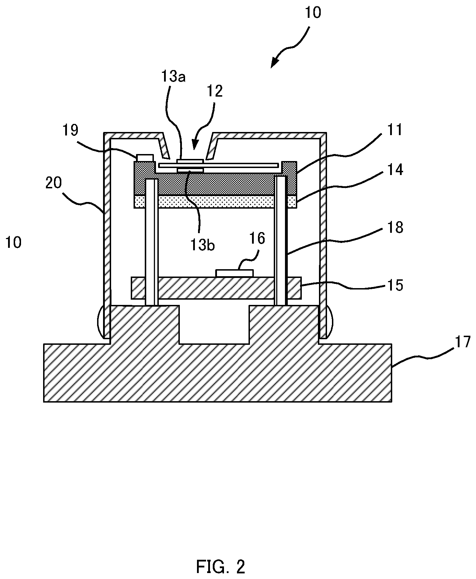

FIG. 2 shows a configuration example of the sensor module 10 according to the present embodiment. FIG. 2 schematically shows a cross section of the sensor module 10. The sensor module 10 includes a substrate 11, a piezoelectric resonator 12, a heater circuit 14, an oscillation circuit 15, a storage circuit 16, a base member 17, a coupling socket 18, a temperature sensor 19, and a cover 20.

The substrate 11 is a substrate for fixing the piezoelectric resonator 12. The substrate 11 is a ceramic substrate such as a Low Temperature Co-fired Ceramics (LTCC) substrate, for example.

The piezoelectric resonator 12 has an electrode 13, and oscillates, when driven by the oscillation circuit 15, at a frequency corresponding to a thickness of a deposit deposited on a surface of the electrode 13. The piezoelectric resonator 12 is a quartz crystal resonator, a ceramic resonator, a Langersite resonator, or the like, for example. In the present embodiment, an example in which the piezoelectric resonator 12 is a two-electrode quartz crystal resonator formed on a quartz substrate composed of a single quartz piece.

One electrode 13a of the piezoelectric resonator 12 is provided on a side opposite to the substrate 11, and is exposed to the outside. The other electrode 13b different from the electrode 13a of the piezoelectric resonator 12 is provided at a position not exposed to the outside. Thus, when the film forming device 4 of the semiconductor manufacturing apparatus 1 starts deposition of the semiconductor material, the semiconductor material is deposited on a surface of the electrode 13a of the piezoelectric resonator 12.

The heater circuit 14 adjusts a temperature of the piezoelectric resonator 12 via the substrate 11. The heater circuit 14 includes a heater that heats the piezoelectric resonator 12, for example. The heater is a Peltier element, a resistor, or a heating wire, for example. The heater may be provided on a surface of the substrate 11 opposite to the piezoelectric resonator 12, and alternatively may be provided on an inner layer of the substrate 11.

The heater circuit 14 has a function of adjusting an amount of heating based on a temperature of the substrate 11 measured by the temperature sensor 19. The heater circuit 14 includes a circuit that adjusts electric power to be supplied to the heater so as to maintain the temperature of the substrate 11 at a predetermined temperature or within a predetermined temperature range. The heater circuit 14 functions as, for example, a heating control unit that controls an amount of heating by the heater based on a difference between a temperature measured by the temperature sensor 19 and a target temperature.

The oscillation circuit 15 has a circuit for driving and oscillating the piezoelectric resonator 12 in accordance with a control signal from the control device 100. When the sensor module 10 includes a plurality of resonators, the oscillation circuit 15 includes circuits corresponding to the plurality of resonators, each circuit being configured to cause a respective resonator to oscillate. The oscillation circuit 15 outputs an oscillation signal of the piezoelectric resonator 12 as an oscillation frequency signal. The oscillation frequency signal output from the oscillation circuit 15 is input to the control device 100 via the connector 5 and the connection cable 30. The oscillation circuit 15 is formed on a predetermined circuit board.

The storage circuit 16 stores, as initial oscillation frequency information, an oscillation frequency measured by causing the piezoelectric resonator 12 to oscillate upon shipment of the piezoelectric resonator 12. The storage circuit 16 is a nonvolatile memory. The storage circuit 16 is preferably a memory readable and rewritable by an electrical signal.

The storage circuit 16 is configured to be capable of updating information by overwriting a storage area for information stored in the past, for example. Thus, when the storage area of the storage circuit 16 is filled with information, an old storage area can be overwritten to store the latest information. The storage circuit 16 may be formed on a circuit board on which the oscillation circuit 15 is formed, or may be formed on another circuit board instead.

The base member 17 is a member for fixing the oscillation circuit 15. The coupling socket 18 is a member for electrically connecting the oscillation circuit 15 and the piezoelectric resonator 12. For example, a pin (not shown in figures) that is electrically connected to the piezoelectric resonator 12 and protrudes from the substrate 11 is inserted into the coupling socket 18. Since the piezoelectric resonator 12 is connected to the oscillation circuit 15 via the pin and the coupling socket 18, even if the temperature varies over a wide range due to heating by the heater circuit 14 and expansion and contraction occurs in respective portions, the coupling socket 18 can absorb stress generated by the expansion and contraction.

The temperature sensor 19 measures a surface temperature of the substrate 11 on which the piezoelectric resonator 12 is provided. The temperature sensor 19 is a resistance temperature detector using platinum or the like, a thermocouple, a thermistor, or the like, for example. The temperature sensor 19 is preferably attached in contact with the substrate 11. In addition, the temperature sensor 19 may be attached in contact with the piezoelectric resonator 12.

The cover 20 covers a portion of the sensor module 10 excluding the electrode 13a, and has a through hole that exposes the electrode 13a. When such a sensor module 10 is installed inside the chamber 2 so that the electrode 13a faces the film forming device 4 of the semiconductor manufacturing apparatus 1, the electrode 13a is deposited with the same material as that deposited on the semiconductor wafer W by the film forming device 4, to the same thickness as on the semiconductor wafer W.

When a substance is deposited on the electrode 13a of the piezoelectric resonator 12, the resonance frequency of the piezoelectric resonator 12 changes in accordance with a thickness of the deposited substance. Therefore, the control device 100 of the measurement system S determines the thickness of the material deposited on the electrode 13a by measuring such a change in the resonance frequency of the piezoelectric resonator 12. Such a control device 100 will be described below.

### <Configuration example of control device 100>

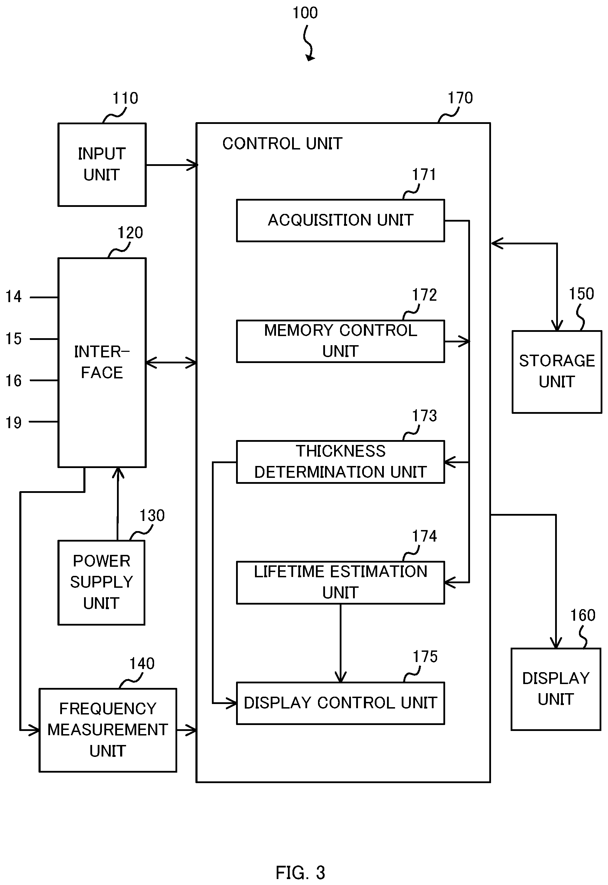

FIG. 3 shows a configuration example of the control device 100 according to the present embodiment. The control device 100 includes an input unit 110, an interface 120, a power supply unit 130, a frequency measurement unit 140, a storage unit 150, a display unit 160, and a control unit 170.

An operation, an instruction, or the like from a user of the control device 100 is input to the input unit 110. The input unit 110 is a part for the user to input a measurement condition for measuring the thickness of the deposit deposited on the sensor module 10. The input unit 110 includes one or more input devices such as a keyboard, a mouse, a touch panel, and a voice input device.

The interface 120 is connected to the connection cable 30 and is connected to the sensor module 10. The interface 120 is a part for transmitting and receiving electrical signals with the sensor module 10. For example, the interface 120 transmits and receives electrical signals between a) the heater circuit 14, the oscillation circuit 15, the storage circuit 16, and the temperature sensor 19 and b) the control device 100.

The power supply unit 130 supplies power to the sensor module 10. The power supply unit 130 is a circuit provided in the sensor module 10 and functions as a power source of the heater. The power supply unit 130 may vary supplied power based on a control operation of the control unit 170.

The frequency measurement unit 140 receives the oscillation frequency signal output from the oscillation circuit 15 via the interface 120. Then, the frequency measurement unit 140 measures the oscillation frequency of the piezoelectric resonator 12 based on the oscillation frequency signal. The frequency measurement unit 140 includes a frequency counter, for example, and measures the oscillation frequency of the oscillation frequency signal.

The frequency measurement unit 140 continuously measures the oscillation frequency of the oscillation frequency signal at least during a deposition period from a start to an end of a deposition operation of the semiconductor material performed by the film forming device 4 of the semiconductor manufacturing apparatus 1. For example, the frequency measurement unit 140 measures the oscillation frequency of the oscillation frequency signal at predetermined time intervals during the deposition period. The frequency measurement unit 140 supplies a measurement result to the control unit 170. The frequency measurement unit 140 preferably supplies the measurement result to the control unit 170 every time the oscillation frequency is measured.

The storage unit 150 is a storage medium including a Read Only Memory (ROM), a Random Access Memory (RAM), and the like. Further, the storage unit 150 may include a mass storage device such as a Hard Disk Drive (HDD) and/or a Solid State Drive (SSD). For example, when a computer or the like functions as at least a part of the control device 100, the storage unit 150 may store information such as an Operating System (OS) that causes the computer to function and a program. Furthermore, the storage unit 150 may store various kinds of information including a database referred to when the program is executed.

Moreover, the storage unit 150 may store intermediate data, a calculation result, a threshold value, a reference value, a parameter, and the like generated (or used) in the process of an operation of the control device 100. For example, the storage unit 150 may store information acquired from the sensor module 10 by the control device 100, or may store information to be written into the storage circuit 16 of the sensor module 10. In addition, the storage unit 150 may supply the stored data to a request source in response to a request from each unit in the control device 100.

The display unit 160 displays information related to the measurement of the thickness of the deposit. The display unit 160 may display a measurement condition, a measurement result, a connection state with the sensor module 10, information of the sensor module 10, and the like, for example. The display unit 160 may also function as a display for displaying the OS, an execution state of an application, and the like. The display unit 160 may have a touch panel function to operate as at least a part of the input unit 110.

The control unit 170 controls each unit of the control device 100 and the sensor module 10. The control unit 170 reads the information stored in the storage unit 150, for example. The control unit 170 may record information in the storage unit 150. For example, the control unit 170 transmits, to the oscillation circuit 15, a control signal for driving the oscillation circuit 15 to cause the oscillation circuit 15 to drive the piezoelectric resonator 12. A more specific operation of the control unit 170 will be described below.

The control unit 170 is a Central Processing Unit (CPU), for example. The control unit 170 includes an acquisition unit 171, a memory control unit 172, a thickness determination unit 173, a lifetime estimation unit 174, and a display control unit 175. In other words, the CPU functions as the control unit 170 including the acquisition unit 171, the memory control unit 172, the thickness determination unit 173, the lifetime estimation unit 174, and the display control unit 175 by executing the program stored in the storage unit 150.

The acquisition unit 171 acquires the measurement result of the oscillation frequency measured by the frequency measurement unit 140. Further, the acquisition unit 171 acquires the measurement result of the temperature of the substrate 11 obtained by the temperature sensor 19. The acquisition unit 171 supplies the acquired measurement result of the oscillation frequency and the measurement result of the temperature to the thickness determination unit 173 and the lifetime estimation unit 174.

The memory control unit 172 is configured to be capable of accessing the storage circuit 16 of the sensor module 10 and reading the information stored in the storage circuit 16. For example, the memory control unit 172 reads and acquires the initial oscillation frequency information stored in the storage circuit 16. The memory control unit 172 supplies the acquired initial oscillation frequency information to the lifetime estimation unit 174. The memory control unit 172 may be configured to be capable of accessing the storage circuit 16 of the sensor module 10 and writing predetermined information into the storage circuit 16.

The thickness determination unit 173 determines the thickness of the deposit deposited on the surface of the electrode 13a of the piezoelectric resonator 12 based on the oscillation frequency measured by the frequency measurement unit 140. The piezoelectric resonator 12 oscillates at a resonance frequency corresponding to the thickness of the deposit deposited on the surface of the electrode 13a. Therefore, the thickness determination unit 173 is capable of determining the thickness of the deposit after a predetermined time t has elapsed, based on a difference in the oscillation frequencies Δf=f2-f1, where f1 is the measurement result of the oscillation frequency at a time when the deposition operation of the semiconductor material performed by the film forming device 4 of the semiconductor manufacturing apparatus 1 is started and f2 is the measurement result of the oscillation frequency after the predetermined time t has elapsed from the start of the deposition operation.

It should be noted that the resonance frequency of the piezoelectric resonator 12 also varies depending on the temperature. Therefore, it is desirable that the thickness determination unit 173 performs temperature compensation on the measurement result of the oscillation frequency measured by the frequency measurement unit 140 using the measurement result of the temperature obtained by the temperature sensor 19. The temperature characteristics of the resonance frequency of the piezoelectric resonator 12 may be measured and determined in advance. Alternatively, when data is disclosed as specifications of the piezoelectric resonator 12, the disclosed data may be acquired. The temperature characteristics of the resonance frequency of the piezoelectric resonator 12 are preferably stored in the storage unit 150.

The thickness determination unit 173 determines a thickness dd of the deposit, for example, based on a difference in the oscillation frequencies Δf'=f2'-f1' calculated from compensated frequencies f1' and f2' obtained by performing the temperature compensation on the measurement results of the oscillation frequencies f1 and f2. A relational expression between the difference in the oscillation frequencies and the thickness of the deposit may be measured in advance to be determined. Alternatively, the relational expression may be determined based on a theoretical formula or the like. The determined relational expression is preferably stored in the storage unit 150. It should be noted that when the heater circuit 14 of the sensor module 10 maintains the temperature of the piezoelectric resonator 12 at a constant temperature, the temperature compensation on the measurement results of the oscillation frequencies f1 and f2 may be omitted.

The thickness determination unit 173 preferably determines the thickness of the deposit every time the frequency measurement unit 140 measures the oscillation frequency. Accordingly, the measurement system S can measure the thickness dd of the deposit deposited on the semiconductor wafer W in substantially real time.

The lifetime estimation unit 174 estimates a lifetime of the piezoelectric resonator 12 based on i) the initial oscillation frequency information read from the storage circuit 16 of the sensor module 10 by the memory control unit 172 and ii) the oscillation frequency measured by the frequency measurement unit 140. When the thickness of the deposit deposited on the surface of the electrode 13a reaches a predetermined thickness, the piezoelectric resonator 12 cannot perform an oscillation operation. The lifetime estimation unit 174 determines, as the lifetime, a measurable range up to a point at which the piezoelectric resonator 12 becomes unable to oscillate.

A deposit thickness dx at which the piezoelectric resonator 12 becomes unable to operate may be measured and determined in advance. Alternatively, when data is disclosed as specifications of the piezoelectric resonator 12, the disclosed data may be acquired. It is desirable that the deposit thickness dx at which the piezoelectric resonator 12 reaches the end of its lifetime is stored in the storage unit 150. Further, the storage circuit 16 of the sensor module 10 may store the deposit thickness dx at which the piezoelectric resonator 12 reaches the end of its lifetime.

The lifetime estimation unit 174 estimates the lifetime of the piezoelectric resonator 12 by comparing a) the compensated frequency obtained by performing the compensation, based on the surface temperature of the substrate 11, on the oscillation frequency measured by the frequency measurement unit 140 with b) the initial oscillation frequency information. For example, the lifetime estimation unit 174 determines a thickness dn of a deposit deposited on the electrode 13a in an initial state, based on a difference between the initial oscillation frequency information and an oscillation frequency Δf0'=f2'-f0, where f0 denotes the initial oscillation frequency information. An equation used by the lifetime estimation unit 174 to calculate the thickness of the deposit from the difference between the oscillation frequencies is the same as the equation used by the thickness determination unit 173 to calculate the thickness of the deposit.

It should be noted that there are some cases where the heater circuit 14 of the sensor module 10 maintains the temperature of the piezoelectric resonator 12 at a temperature at which the initial oscillation frequency information of the piezoelectric resonator 12 was measured. In this case, the lifetime estimation unit 174 may omit the temperature compensation on the oscillation frequency measurement result f2.

It should be noted that, when the piezoelectric resonator 12 in the initial state after shipment is mounted on the sensor module 10 and the thickness of the deposit is measured for the first time, the thickness dn of the deposit deposited on the electrode 13a in the initial state is equal to the thickness dd of the deposit determined by the thickness determination unit 173. When one or more measurements have been performed before the current measurement of the deposit thickness, a thickness obtained by adding the thickness dd of the deposit deposited by the current measurement to a thickness of a deposit deposited up to a previous measurement is equal to the thickness dn of the deposit deposited from the initial state of the electrode 13a.

The lifetime estimation unit 174 calculates a difference Δd=dx-dn between a) the deposit thickness dx at which the piezoelectric resonator 12 reaches the end of its lifetime and b) the determined deposit thickness dn. The difference Δd is a thickness of the deposit that can be measured by the piezoelectric resonator 12. For example, the lifetime estimation unit 174 determines a measurable deposit thickness Δd as the lifetime. Alternatively or additionally, the lifetime estimation unit 174 may calculate an oscillation frequency difference Δfx corresponding to the measurable deposit thickness Δd and determine the difference Δfx as the lifetime.

In addition, the lifetime estimation unit 174 may calculate an estimated lifetime corresponding to the measurable deposit thickness Δd. For example, the lifetime estimation unit 174 defines, as an estimated deposition rate vv, a value obtained by dividing a deposit thickness, which is determined based on oscillation frequency measurement results measured at two different times by the frequency measurement unit 140, by a time interval between the two times. Then, the lifetime estimation unit 174 defines, as an estimated lifetime vt, a value obtained by dividing the measurable deposit thickness Δd by the estimated deposition rate vv.

For example, when the deposit thickness dd after the predetermined time t has elapsed is measured, the lifetime estimation unit 174 calculates the estimated deposition rate vv as dd/t and the estimated lifetime vt as Δd/vv=Δd·t/dd. The lifetime estimation unit 174 may determine the estimated lifetime vt calculated in this manner as the lifetime. Accordingly, the lifetime estimation unit 174 can determine, as the lifetime, a time required for the piezoelectric resonator 12 to reach the measurement limit when the deposition is performed at a constant deposition rate.

The lifetime estimation unit 174 preferably estimates the lifetime of the piezoelectric resonator 12 every time the frequency measurement unit 140 measures the oscillation frequency. Accordingly, the measurement system S can measure the lifetime of the piezoelectric resonator 12 of the sensor module 10 in substantially real time.

The display control unit 175 displays the deposit thickness determined by the thickness determination unit 173 and the lifetime of the piezoelectric resonator 12 estimated by the lifetime estimation unit 174 on the display unit 160. This allows the user of the measurement system S to grasp the thickness of the deposited semiconductor material and the lifetime of the piezoelectric resonator 12 of the sensor module 10 while depositing the semiconductor material on the semiconductor wafer W using the semiconductor manufacturing apparatus 1. Thus, the user can determine an appropriate timing for replacing the sensor module 10.

For example, after the deposition operation of the semiconductor material by the film forming device 4 of the semiconductor manufacturing apparatus 1 is completed, the lifetime of the piezoelectric resonator 12 estimated by the lifetime estimation unit 174 indicates a measurement limit up to which the measurement system S can measure the next deposit thickness. Therefore, the user can easily determine whether to continue an operation of the semiconductor manufacturing apparatus 1 or to resume the operation after replacing the sensor module 10.

It should be noted that the control device 100 may measure the lifetime of the piezoelectric resonator 12 immediately after being powered on and becoming ready to measure a deposit thickness. In addition, the control device 100 may measure the lifetime of the piezoelectric resonator 12 in response to the user inputting the measurement condition to the input unit 110. Thus, the user can easily determine whether to replace the sensor module 10 before starting the operation of the semiconductor manufacturing apparatus 1. Next, the operation of the control device 100 will be described.

### <Operational flow of control device 100>

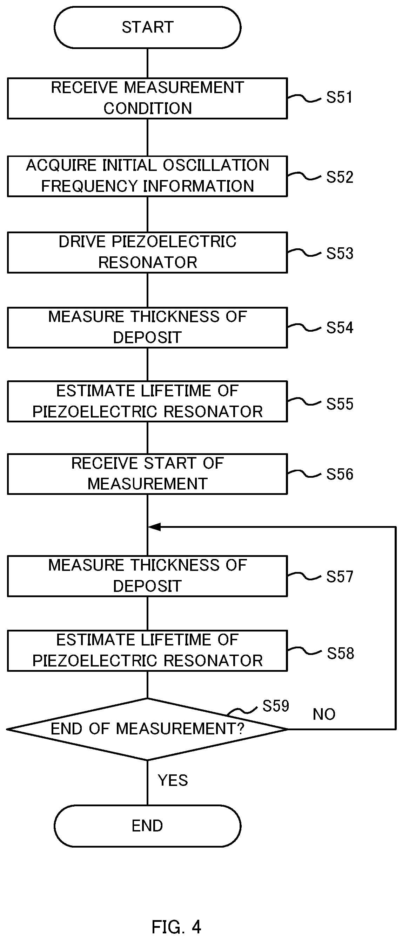

FIG. 4 shows an operational flow of the control device 100 according to the present embodiment. First, the input unit 110 receives the measurement condition input by the user (S51). The measurement condition may include information on the thickness of the semiconductor material to be deposited on the semiconductor wafer W. Next, the memory control unit 172 accesses the storage circuit 16 of the sensor module 10 and reads and acquires the initial oscillation frequency information stored in the storage circuit 16 (S52). Then, the control unit 170 causes the oscillation circuit 15 to drive the piezoelectric resonator 12 (S53).

Next, the control unit 170 measures the thickness of the deposit deposited on the piezoelectric resonator 12 (S54). In this case, the frequency measurement unit 140 measures the oscillation frequency of the piezoelectric resonator 12, and the acquisition unit 171 acquires the measurement result of the oscillation frequency and the measurement result of the temperature obtained by the temperature sensor 19. Then, the thickness determination unit 173 measures the thickness of the deposit deposited on the piezoelectric resonator 12 based on the measurement result of the oscillation frequency and the measurement result of the temperature. The display control unit 175 displays the determined deposit thickness on the display unit 160.

Subsequently, the control unit 170 estimates the lifetime of the piezoelectric resonator 12 (S55). In this case, the lifetime estimation unit 174 estimates the lifetime of the piezoelectric resonator 12 based on the measurement result of the oscillation frequency, the measurement result of the temperature, and the initial oscillation frequency information. The display control unit 175 displays the estimated lifetime of the piezoelectric resonator 12 on the display unit 160. Thus, the user can grasp the information on the piezoelectric resonator 12 before the semiconductor material is deposited on the semiconductor wafer W.

Next, the input unit 110 receives an indication to start measurement from the user (S56). Here, for example, it is assumed that the user inputs an instruction to start measurement to the input unit 110 in response to the start of deposition of the semiconductor material by the film forming device 4 of the semiconductor manufacturing apparatus 1. Alternatively, when a measurement start time is included in the measurement conditions input by the user, the control unit 170 may start the measurement in response to the measurement start time being reached. Further, the control device 100 may be connected to a control device that controls the operation of the semiconductor manufacturing apparatus 1 via a network or the like, and in this case, the control device 100 may receive a start signal for starting measurement from the control device of the semiconductor manufacturing apparatus 1.

The control device 100 measures the deposit thickness in the same manner as the operation of S54 (S57), and estimates the lifetime of the piezoelectric resonator 12 in the same manner as the operation of S55 (S58). The control device 100 repeats the operations of S57 and S58 (S59: No) until the input unit 110 receives an instruction to end the measurement (S59: Yes). Here, it is assumed that the user inputs the instruction to end the measurement to the input unit 110 in response to, for example, completion of the deposition of the semiconductor material by the film forming device 4 of the semiconductor manufacturing apparatus 1. Alternatively, when the measurement end time is included in the measurement conditions input by the user, the control unit 170 may end the measurement in response to the measurement end time being reached. Further, the control device 100 may receive an end signal for ending the measurement from the control device of the semiconductor manufacturing apparatus 1.

According to the measurement system S of the present embodiment described above, by storing the initial oscillation frequency information of the piezoelectric resonator 12 in the storage circuit 16 of the sensor module 10, the memory control unit 172 of the control device 100 can read the initial oscillation frequency information and estimate the lifetime of the piezoelectric resonator 12. Thus, when the semiconductor manufacturing apparatus 1 deposits the semiconductor material on the semiconductor wafer W, the lifetime of the piezoelectric resonator 12 can be measured while measuring the thickness of the deposited semiconductor material in substantially real time.

Therefore, the user can replace the sensor module 10 at an appropriate timing, and it is possible to prevent the piezoelectric resonator 12 from being unable to operate while the semiconductor manufacturing apparatus 1 is depositing the semiconductor material. In addition, when the sensor module 10 is replaced, the control device 100 reads the initial oscillation frequency information stored in the storage circuit 16 of the sensor module 10 after replacement, thereby estimating the lifetime of the piezoelectric resonator 12 after replacement.

### <Other configurations>

In the measurement system S according to the present embodiment described above, the user replaces the sensor module 10 before the piezoelectric resonator 12 becomes unable to operate. The user may replace the piezoelectric resonator 12 of the sensor module 10. When the user replaces the piezoelectric resonator 12 of the sensor module 10, the measurement system S may update the initial oscillation frequency information of the piezoelectric resonator 12 before replacement in the storage circuit 16 to the initial oscillation frequency information of the piezoelectric resonator 12 after replacement.

In this case, for example, the frequency measurement unit 140 measures the oscillation frequency of the piezoelectric resonator 12 after replacement, and the memory control unit 172 writes, as the initial oscillation frequency information, the measurement result obtained by the frequency measurement unit 140 in the storage circuit 16. Thus, the measurement system S can estimate the lifetime of the piezoelectric resonator 12 after replacement.

An example has been described in which, in the measurement system S according to the present embodiment described above, the initial oscillation frequency information of the piezoelectric resonator 12 is stored in the storage circuit 16 of the sensor module 10, but the present disclosure is not limited thereto. In addition to the above, the storage circuit 16 may store information of at least one of a first identification number for identifying the piezoelectric resonator 12 or a second identification number for identifying the sensor module 10.

When the storage circuit 16 stores the first identification number and/or the second identification number, the memory control unit 172 may read the first identification number and/or the second identification number when reading the initial oscillation frequency information. In this case, the display control unit 175 causes the display unit 160 to display the read first identification number and/or second identification number. Accordingly, the user can grasp information for identifying the sensor module 10 and/or the piezoelectric resonator 12 to be used for measurement and utilize the information for maintenance, management, and the like of the sensor module 10 and/or the piezoelectric resonator 12.

An example has been described in which, in the measurement system S according to the present embodiment described above, the sensor module 10 stores, as the initial oscillation frequency information, the oscillation frequency measured by causing the piezoelectric resonator 12 to oscillate upon shipment of the piezoelectric resonator 12 by the storage circuit 16, but the present disclosure is not limited thereto. The storage circuit 16 may record information for estimating the lifetime of the piezoelectric resonator 12.

For example, the storage circuit 16 may store, as the initial oscillation frequency information, an oscillation frequency measured by causing the piezoelectric resonator 12 to oscillate when the measurement system S is installed. For example, when the frequency measurement unit 140 measures the oscillation frequency of the piezoelectric resonator 12 after the input unit 110 receives a predetermined operation indicating that the measurement system S is installed, the memory control unit 172 updates the initial oscillation frequency information stored in the storage circuit 16 to the measured oscillation frequency information of the piezoelectric resonator 12.

Thus, for example, when the measurement system S is applied to the semiconductor manufacturing apparatus 1 to construct a semiconductor manufacturing system, the storage circuit 16 can reliably store an initial value of the piezoelectric resonator 12 actually mounted on the sensor module 10. In addition, the storage circuit 16 may further store information on environmental temperature at the time of measuring the initial oscillation frequency information. It should be noted that although an example in which the measurement system S according to the present embodiment is applied to the semiconductor manufacturing apparatus 1 has been described, this is merely an example. The measurement system S is applicable not only to the semiconductor manufacturing apparatus 1 but also to any apparatus that deposits a deposit.

The present disclosure is explained on the basis of the exemplary embodiments. The technical scope of the present disclosure is not limited to the scope explained in the above embodiments and it is possible to make various changes and modifications within the scope of the disclosure. For example, all or part of the apparatus can be configured with any unit which is functionally or physically dispersed or integrated. Further, new exemplary embodiments generated by arbitrary combinations of them are included in the exemplary embodiments of the present disclosure. Further, effects of the new exemplary embodiments brought by the combinations also have the effects of the original exemplary embodiments.

### [Description of Symbols]

1: semiconductor manufacturing apparatus
2: chamber
3: stage
4: film forming device
5: connector
10: sensor module
11: substrate
12: piezoelectric resonator
13: electrode
14: heater circuit
15: oscillation circuit
16: storage circuit
17: base member
18: coupling socket
19: temperature sensor
20: cover
30: connection cable
100: control device
110: input unit
120: interface
130: power supply unit
140: frequency measurement unit
150: storage unit
160: display unit
170: control unit
171: acquisition unit
172: memory control unit
173: thickness determination unit
174: lifetime estimation unit
175: display control unit

## Claims

1. A sensor module comprising:
a piezoelectric resonator that includes an electrode;
an oscillation circuit that drives and oscillates the piezoelectric resonator; and
a storage circuit that stores, as initial oscillation frequency information, an oscillation frequency measured by causing the piezoelectric resonator to oscillate upon shipment of the piezoelectric resonator, wherein
the piezoelectric resonator, when driven by the oscillation circuit, oscillates at a frequency corresponding to a thickness of a deposit deposited on a surface of the electrode.

2. The sensor module according to claim 1, wherein
the storage circuit further stores information of an identification number of at least one of a first identification number for identifying the piezoelectric resonator or a second identification number for identifying the sensor module.

3. The sensor module according to claim 2, wherein
the storage circuit is configured to be capable of updating information by overwriting a storage area for information stored in the past.

4. A measurement system comprising:
the sensor module according to any one of claims 1 to 3; and
a control device that is connected to the sensor module, wherein
the control device includes:
a frequency measurement unit that measures an oscillation frequency of the piezoelectric resonator based on an oscillation frequency signal output from the oscillation circuit,
a memory control unit that is capable of accessing the storage circuit of the sensor module to read information stored in the storage circuit,
a thickness determination unit that determines the thickness of the deposit deposited on the surface of the electrode of the piezoelectric resonator based on the oscillation frequency measured by the frequency measurement unit, and
a lifetime estimation unit that estimates a lifetime of the piezoelectric resonator based on the initial oscillation frequency information read from the storage circuit by the memory control unit and the oscillation frequency measured by the frequency measurement unit.

5. The measurement system according to claim 4, wherein
the sensor module further includes:
a temperature sensor that measures a surface temperature of a substrate provided with the piezoelectric resonator, and
an acquisition unit that acquires a measurement result obtained by the temperature sensor, wherein
the lifetime estimation unit estimates the lifetime of the piezoelectric resonator by comparing the initial oscillation frequency information with a compensated frequency obtained by performing a compensation, based on the surface temperature of the substrate, on the oscillation frequency measured by the frequency measurement unit.

6. The measurement system according to claim 5, wherein
the control device further includes an input unit that allows a user to input a measurement condition for measuring the thickness of the deposit,
the memory control unit is capable of accessing the storage circuit of the sensor module to write predetermined information to the storage circuit, and
when the frequency measurement unit measures the oscillation frequency of the piezoelectric resonator after the input unit receives a predetermined operation indicating that the measurement system is installed, the memory control unit updates the initial oscillation frequency information stored in the storage circuit to the measured oscillation frequency information of the piezoelectric resonator.
